(19) Europäisches Patentamt
European Patent Office
Office européen des brevets

(11) Publication number: 0 320 907 A2

# (12) EUROPEAN PATENT APPLICATION

(21) Application number: 88120903.5

(51) Int. Cl.4: G03F 7/10

(22) Date of filing: 14.12.88

(30) Priority: 16.12.87 JP 316117/87

(43) Date of publication of application: 21.06.89 Bulletin 89/25

(84) Designated Contracting States: BE DE FR GB NL

(71) Applicant: Tosoh Corporation
4560, Oaza Tonda
Shinnanyo-shi Yamaguchi-ken(JP)

(72) Inventor: Sakurai, Ikuo
3056-1, Oaza Tonda
Shinnanyo-shi Yamaguchi-ken(JP)
Inventor: Hasegawa, Masazumi
4-10-3-118, Madokoro
Shinnanyo-shi Yamaguchi-ken(JP)

(74) Representative: Vossius & Partner
Siebertstrasse 4 P.O. Box 86 07 67
D-8000 München 86(DE)

## (54) Photosensitive resin composition and method of producing fine patterns therewith.

(57) Photosensitive resin composition comprising a diazonium salt having $^-BF_4$ and/or $^-PF_6$ as a counter anion, an alkali soluble polymer and/or a water soluble polymer and a solvent which does not solve a positive photoresist, and method of producing fine patterns which comprises applying a resist as a lower layer on a substrate and applying the above photosensitive resin composition as an upper layer on the lower layer and exposing both layers to light to produce fine patterns.

EP 0 320 907 A2

Xerox Copy Centre

# PHOTOSENSITIVE RESIN COMPOSITION AND METHOD OF PRODUCING FINE PATTERNS THEREWITH

The present invention relates to a photosensitive resin composition for forming fine patterns to be used in the field of semiconductors and the method of forming said patterns. More particularly, this invention relates to photosensitive resin composition suitable to the improvement of the dimensional precision and resolution of fine patterns by coating a positive photoresist (as lower layer) on a substrate and furthermore the photosensitive resin composition (as upper layer) on the lower layer and then exposing to light to get the more increased contrast, and also relates to the method of producing fine patterns using said resin composition.

With the increase of integration scale of semiconductors, there is an increasing tendency to reduction of patterns in size. In recent years, it has been demanded to produce a high-precise pattern profile of 1 µm or less in line width, and various methods have been proposed to meet this demand.

In regard to apparatus, for example,

(1) Use of a light source of shorter wave lengths, and

(2) Use of lenses of a large numerical aperture.

These two items are expected to improve the resolution through the theory on optics and actually pilot apparatuses are commercially available. However, these improvements are not free of problems. Thus, if the light source is of shorter wave lengths, transmittance of the lens becomes too low to obtain transmitted light quantity. When a lens of a large numerical aperture is used, a shallower focus length does not permit a precise projection of patterns on an uneven surface.

With respect to resists on the other hand, attempts are made to develop those resists having a high contrast (so-called high resist). Indeed, a high resist somewhat improves the resolution. The production of a high resist can be achieved by adjusting the molecular weight and its dispersity of the polymer in the resist. But there exists a restriction on the materials to be used and it has not yet been sufficient to improve the resolution.

Speaking of lithography there are devised two methods, that is,

(1) a method using a multilayer resist, and

(2) a method of coating a photosensitive resin composition on the film of the resist.

Indeed, a multilayer resist affords the fine resolution as much as less than 1 µm of a pattern, but it let production time of semiconductors become longer because of the complexity of the process. Low yield is an additional drawback of this method. Thus, it remains still incomplete as an industrial process.

Application of a photosensitive resin composition on a resist film intends the following effect: Light after passing through a mask keeps high contrast, but the contrast becomes worse after it passes through the space and a lens. The lowered contrast of light can be better improved again on passage through a photosensitive resin layer. As the result,the resolution of the pattern is improved. Generally a photosensitive resin composition consists of a photobleachable agent, a polymer and a solvent. A photosensitive resin composition using a diazonium salt as photobleachable agent is proposed in JP-A-60-238829.

However, since an organic solvent in the photosensitive resin composition mentioned above dissolves the resist, an interlayer has to intervene between the lower layer photoresist and the photosensitive resin composition layer (upper layer). This leads to complexity in the process to produce fine pattern and a low yield of the product. In addition, the improvement of resolution is not completely satisfactory even if said photosensitive resin composition is used and unstability of the diazonium salt provides further problem.

The present inventors attempted to evaluate the degree of resolution according to the method proposed for the evaluation of positive photoresist (IBM Corporation in USA: F.H.Drill et al., "Characterization of positive photoresist, IEEE Transaction on Electron Devices, Vol. ED-22, No. 7, July 1975) and investigation revealed that an increase in the A value resulted in remarkable improvement of resolution.

Generally the A value is expressed as follows

$$A = \frac{I}{d} \ln \frac{T(\infty)}{T(0)}$$

where T(0) : initial transmittance

T(∞) : final transmittance
d : thickness of the film.

Therefore, a larger value of A could be obtained when the film is thinner, the photosensitive layer (upper layer) has higher transmittance after the bleaching (in other words, the T(∞) value is as close as 100 %) and the value of initial transmittance T(0) is as low as possible. The T(0) value can be made lower when the concentration of diazonium salt as photobleachable agent in the photosensitive resin composition is higher. But a high concentration of the salt results in deposition of the salt by crystallization after coating the photosensitive resin composition on the resist, leading to undesired lower resolution. If an additive is used to increase the solubility of the diazonium salt, the coating property will be lowered.

The present inventors performed their investigation to solve the above problems. Eventually they found that the use of a solvent which does not dissolve a positive photoresist, but dissolves the photosensitive resin composition provides the fine pattern without interlayer between the layers of photoresist (lower layer) and photosensitive resin composition (upper layer). And the counter anions of diazonium salts, $^{-}BF_4$ and/or $^{-}PF_6$, are remarkably dissolved in the above solvents. Thus, the present invention has been completed.

The present invention consists of photosensitive resin composition and a method of producing fine patterns by applying the said composition. The photosensitive resin composition is composed of a diazonium salt of which the counter anion is $^{-}BF_4$ and/or $^{-}PF_6$, an alkali soluble polymer and/or a water soluble polymer, and a solvent which does not dissolve a positive photoresist. The method of producing fine patterns in which a resist is coated as lower layer on a substrate and a photosensitive resin composition is coated as the upper layer on the lower layer and both layers are exposed to light and developed comprises the photosensitive resin composition being composed of a diazonium compound of which the counter anion is $^{-}BF_4$ and/or $^{-}PF_6$, an alkali soluble polymer and/or water soluble polymer and a solvent which does not dissolve a positive photoresist. The present invention will be explained in more details below.

The resists as object of this invention are positive photoresists composed of either novolak or polyhydroxystyrene resin as major component. Solvents of this invention for dissolving photosensitive resin composition are those which do not dissolve these photoresists. They include, for example, acetonitrile, nitromethane, diacetone alcohol, trichloroethane, dichloroethylene, dichloroethane, tetrachloroethylene, chlorobenzene, diisobutylketone, γ-butyllactone and propylene carbonate, mixtures of more than two of them, and those solvents of which the mentioned solvents are the major constituent.

The diazonium salts to be used in the photosensitive resin compositions of this invention are selected from those of which counter anions are $^{-}BF_4$ and/or $^{-}PF_6$ from the standpoint of their solubility in said solvents, where the counter cations may be the known ones which sufficiently absorb the wavelength of light employed for the exposure. For instance, when light at the g line (436 nm) is used, the counter cations are expressed by the following general formula

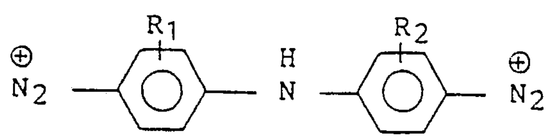

or

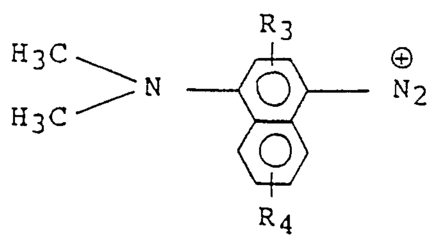

(where $R_1$ to $R_4$ stand for a hydrogen atom, an alkyl, alkoxy or nitro group) and, when light at the i line (365 nm) is used, the counter cation is expressed by the following general formula:

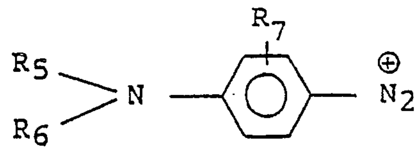

or

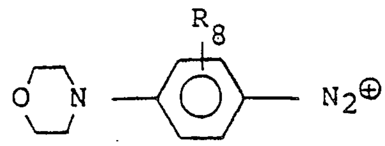

(where $R_5$ and $R_6$ stand for a hydrogen atom, an alkyl, acetyl group and $R_7$ and $R_8$ stand for a hydrogen atom, an alkyl, alkoxy, hydroxy or nitro group). Among them, the diazonium salt is preferred to g line from the solubility consideration. Further, preferred is this diazonium salt in combined use with nitromethane and/or chloroethane as solvent.

The polymer of the photosensitive resin composition of this invention should be an alkali- and/or water-soluble polymer. Since an alkaline developer and/or water are usually used for developing positive photoresists, said polymer is dissolved in the developer of photoresist and therefore the pattern which employs the photosensitive resin composition is easily prepared. The polymers employable include polymers and copolymers of vinylpyrrolidone, acrylic acid, methacrylic acid, oxazolidone, crotonic acid, vinyl alcohol, maleic acid anhydride, maleic imide, maleic imide derivatives, acrylic amide, and acrylic amide derivatives, and copolymers of said compounds with other compounds.

In addition, various additives such as surface active agents, phosphoric acid, benzenesulfuric acid and its salts, sulfosalicylic acid and its salts, nicotinic acid and caffeine may be added to the photosensitive resin composition to increase the solubility of the diazonium salts.

In the next place, the method will be described by which fine patterns are practically produced using the photosensitive resin composition of this invention.

At first, a positive photoresist is coated on a substrate with a spinner. Then, after prebake is conducted, the photosensitive resin composition of this invention is directly spincoated on the resist layer (lower layer) to form the layer of the photosensitive resin composition (upper layer). Then the layers are exposed to light to which both upper and lower layer are sensitive and developed with a developer for photoresist used. Thus, both the photosensitive resin composition layer and the part of the resist layer which was exposed to light are dissolved into the developer to give a desired fine pattern.

According to the present invention, the A value which is one of the factors of improved resolution can be increased by dissolving a larger amount of diazonium salt in the photosensitive resin composition, and also stability of the diazonium salt can be improved. Thus, a resist pattern of less than 1 $\mu m$ resolution can be obtained in a rather simple process with sufficient reproducibility and resolution. This fact remarkably contributes to the finer lithography which is adequate to the dimensions of circuit patterns appearing in the semiconductor production, and promises high merits enough used in industry.

The present invention will be described in more details using examples, but is not restricted thereto.

## Example 1

Into an aqueous solution of 4-$\alpha$-naphthylaminobenzene diazoniumchloride, 1.05 times as much as the equivalent of $HBF_4$ was added, the precipitate was recovered and diazonium salt powder was obtained by drying in vacuum. Then 10 g of the diazonium salt was mixed with 6.7 g of polyvinylpyrrolidone (molecular weight 24,500 produced by Nakarai Chemicals Ltd.) and 120 g of nitromethane to produce a photosensitive resin composition.

The photosensitive resin composition was coated with a spinner onto a quartz substrate to form a 0.57 $\mu m$ thick uniform film. The A value at 365 nm was 14.5 as evaluated from the transmittance values before and after the exposure to light. This photosensitive resin compound was kept in a thermostat at 40 °C for 30 days and then the same evaluation was conducted. As the result, the thickness of the film did not change and the A value was 14.7. It was suggested that this photosensitive resin composition showed good stability.

Example 2

A positive photoresist OFPR-800 (produced by Tokyo Ohka Kogyo Co., Ltd.) was spincoated onto a silicon wafer in a thickness of 0.9 µm, prebaked at 80°C for 10 min, and the photosensitive resin compound prepared in Example 1 was spincoated directly on the resist layer in a thickness of 0.50 µm. This was exposed with a 10 : 1 reduction exposure machine (stepper) with lens of a numerical aperture 0.42, and developed with NMD-3 (developer; Tokyo Ohka Kogyo Co., Ltd.). A pattern profile of resist was observed with an electron microscope to get a pattern of 0.60 µm line/space with rectangular steep edges.

Example 3

N,N-Dimethylnaphthylamine in an aqueous hydrochloric acid solution was reacted in the usual method to produce dimethylaminonaphthalene diazonium chloride, via a nitroso compound. Then an equimolar amount of $HPF_6$ was added and a precipitate was recovered and then the diazonium salt powder were obtained by the vacuum drying.

Then 7.5 g of the diazonium salt obtained and 5.0 g of a 1 : 1 copolymer (molecular weight = 5700) of styrene and maleic acid anhydride were added to 92 g of nitromethane to produce a photosensitive resin composition.

The photosensitive resin composition was kept for 35 days in a 40°C thermostat. The A value which was 13.1 before the storage was evaluated to be 13.2, thus revealing high stability on storage.

Example 4

A positive photoresist OFPR-800 (produced by Tokyo Ohka Kogyo Co., Ltd.) was coated on a silicon wafer by the spinner in a thickness of 1.0 µm. This was prebaked at 80°C for 10 min and then the photosensitive resin composition prepared in Example 3 was spincoated on it in a thickness of 0.52 µm.

Exposure was conducted with a 5 : 1 reduction stepper equipped with a lens of numerical aperture 0.35, and then development was conducted with NMD-3 (produced by Tokyo Ohka Kogyo Co. Ltd.).

The $\gamma$ value which is a measure of the resolution and shape of pattern was 17.2. From observation of the pattern profile with an electron microscope, it was shown that 0.65 µm line/space pattern with rectangular was obtained.

Comparison Example 1

A positive photoresist OFPR-800 (produced by Tokyo Ohka Kogyo Co., Ltd.) was spincoated on a silicon wafer in a thickness of 1.0 µm. This was prebaked at 80°C for 10 min and, exposed by the reduction stepper employed in Example 4 without coating any photosensitive resin composition. Then the wafer was developed with NMD-3 (produced by Tokyo Ohka Kogyo Co., Ltd.). The $\gamma$ value was 1.92. From observation of the pattern with an electron microscope it was revealed that 1.0 µm of pattern could not be obtained.

Example 5

The compound of formula (I) (diazonium salt)

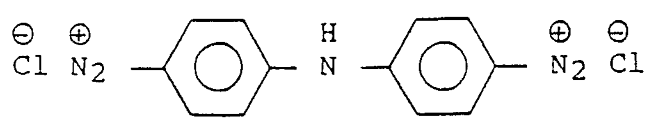

(I)

was prepared according to an ordinary method in aqueous hydrochloric acid. And then twice as much as equivalent of $HBF_4$ was added in this solution, and a precipitate was recovered and dried in vacuum to obtain the diazonium salt indicated by the formula (II),

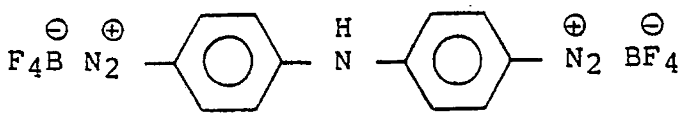

(II)

Subsequently, 5.1 g of the diazonium salt obtained and 4.2 g of a 1 : 1 copolymer (molecular weight = 6200) of styrene and maleic imide were added to a mixed solvent composed of 10 % by weight of 1,1,1-trichloroethane and 90 % by weight of nitromethane, to prepare a photosensitive resin composition.

A positive photoresist OFPR-800 (produced by Tokyo Ohka Kogyo Co., Ltd.) was coated on a silicon wafer by the spinner in a thickness of 1.0 µm. This was prebaked at 80°C for 10 min and then the photosensitive resin composition prepared was spincoated on it in a thickness of 0.48 µm.

Exposure was done with a 5 : 1 reduction stepper equipped with a lens of numerical aperture 0.35, and then development was done with NMD-3 (produced by Tokyo Ohka Kogyo Co., Ltd.). The γ value obtained was 16.5 and from observation of the resist pattern with an electron microscope, it was revealed that a 0.65 µm pattern with rectangular steep edges was obtained.

## Claims

1. Photosensitive resin composition comprising a diazonium salt, a polymer and a solvent, wherein the diazonium salt has $^{-}BF_4$ and/or $^{-}PF_6$ as a counter anion, the polymer is an alkali soluble polymer and/or a water soluble polymer and the solvent is one which does not dissolve a positive photoresist.

2. Photosensitive resin composition according to claim 1, in which the solvent or a main constituent of the solvent is one or more of acetonitrile, nitromethane, diacetone alcohol, trichloroethane, dichloroethylene, dichloroethane, tetrachloroethylene, chlorobenzene, diisobutylketone, γ-butyllactone and propylene carbonate.

3. Photosensitive resin composition according to claim 1, wherein the polymer is a polymer or copolymer of vinylpyrrolidone, acrylic acid, methacrylic acid, oxazolidone, crotonic acid, vinyl alcohol, maleic acid anhydride, maleic imide, maleic imide derivatives, acrylic amide, and acrylic amide derivatives, or a copolymer of said compounds with other compounds.

4. Photosensitive resin composition according to claim 1, wherein the diazonium salt has a counter cation having the following formula:

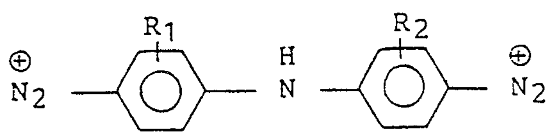

or

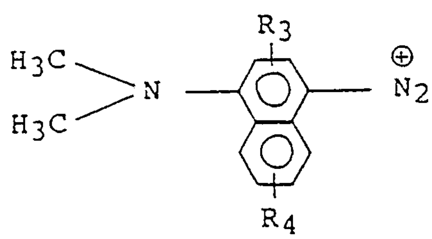

where $R_1$ - $R_4$ stand for a hydrogen atom, an alkyl, alkoxy or nitro group.

5. Photosensitive resin composition according to claim 1, wherein the diazonium salt has a counter cation having the following general formula:

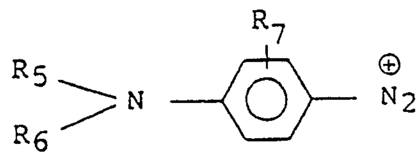

or

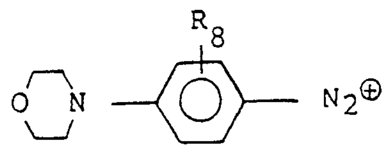

where $R_5$ and $R_6$ stand for a hydrogen atom, an alkyl, acetyl group and $R_7$ and $R_8$ stand for a hydrogen atom, an alkyl, alkoxy, hydroxy or nitro group.

6. Method of producing fine patterns comprising applying a resist as a lower layer on a substrate and a photosensitive resin composition as an upper layer on said lower layer and exposing both layers to light to produce a fine pattern, wherein the photosensitive resin composition is a composition according to any one of claims 1 to 5.

7. Method according to claim 6, wherein the resist is a positive photoresit.